# EUROPÄISCHE PATENTSCHRIFT

(11) **EP 3 256 835 B1**
(45) Veröffentlichungstag und Bekanntmachung des Hinweises auf die Patenterteilung: **14.08.2019**
(21) Anmeldenummer: 16703455.2
(22) Anmeldetag: 29.01.2016
(51) Int. Cl.: G03F 7/20, G01M 11/02, G01B 9/021, G01B 9/02, G01M 11/00

(54) **PRÜFVORRICHTUNG SOWIE VERFAHREN ZUM PRÜFEN EINES SPIEGELS**
TEST DEVICE AND METHOD FOR TESTING A MIRROR
DISPOSITIF DE TEST ET PROCÉDÉ DE TEST D'UN MIROIR

(30) Priorität: 13.02.2015 DE 102015202695
(43) Veröffentlichungstag der Anmeldung: 20.12.2017
(73) Patentinhaber: Carl Zeiss SMT GmbH, 73447 Oberkochen (DE)
(72) Erfinder: STIEPAN, Hans-Michael, 73433 Aalen (DE); HETZLER, Jochen, 73433 Aalen (DE); FUCHS, Sebastian, 73433 Aalen (DE)
(74) Vertreter: Frank, Hartmut
(86) Internationale Anmeldenummer: PCT/EP2016/051957
(87) Internationale Veröffentlichungsnummer: WO 2016/128234

(56) Entgegenhaltungen:
- DE-A1-102008 048 844
- DE-A1-102012 217 800
- US-A1- 2012 170 038

## Beschreibung

### Gebiet der Erfindung

Die Erfindung betrifft eine Prüfvorrichtung sowie ein Verfahren zum Prüfen eines Spiegels, insbesondere eines Spiegels einer mikrolithographischen Projektionsbelichtungsanlage.

### Stand der Technik

Mikrolithographie wird zur Herstellung mikrostrukturierter Bauelemente, wie beispielsweise integrierter Schaltkreise oder LCD's, angewendet. Der Mikrolithographieprozess wird in einer sogenannten Projektionsbelichtungsanlage durchgeführt, welche eine Beleuchtungseinrichtung und ein Projektionsobjektiv aufweist. Das Bild einer mittels der Beleuchtungseinrichtung beleuchteten Maske (= Retikel) wird hierbei mittels des Projektionsobjektivs auf ein mit einer lichtempfindlichen Schicht (Photoresist) beschichtetes und in der Bildebene des Projektionsobjektivs angeordnetes Substrat (z.B. ein Siliziumwafer) projiziert, um die Maskenstruktur auf die lichtempfindliche Beschichtung des Substrats zu übertragen.

In für den EUV-Bereich ausgelegten Projektionsobjektiven, d.h. bei Wellenlängen von z.B. etwa 13 nm oder etwa 7 nm, werden mangels Verfügbarkeit geeigneter lichtdurchlässiger refraktiver Materialien Spiegel als optische Komponenten für den Abbildungsprozess verwendet. Typische für EUV ausgelegte Projektionsobjektive, wie z.B. aus US 7,538,856 B2 bekannt, können beispielsweise eine bildseitige numerische Apertur (NA) im Bereich von NA = 0.2 bis 0.3 aufweisen und bilden ein (z.B. ringsegmentförmiges) Objektfeld in die Bildebene bzw. Waferebene ab.

Dabei ist u.a. auch der Betrieb von Spiegeln unter streifendem Einfall bekannt. Unter solchen unter streifendem Einfall betriebenen Spiegeln, deren Einsatz grundsätzlich im Hinblick auf die vergleichsweise hohen erreichbaren Reflektivitäten (von z.B. 80% und mehr) wünschenswert ist, werden z.B. Spiegel verstanden, für welche die bei der Reflexion der EUV-Strahlung auftretenden, auf die jeweilige Oberflächennormale bezogenen Reflexionswinkel wenigstens 65° betragen. Solche Spiegel werden auch als GI-Spiegel ("**g**razing **i**ncidence" = "streifender Einfall") bezeichnet.

Mit der Erhöhung der bildseitigen numerischen Apertur (NA) sowie auch mit der Realisierung von Anordnungen mit GI-Spiegeln geht typischerweise eine Vergrößerung der erforderlichen Spiegelflächen der in der Projektionsbelichtungsanlage eingesetzten Spiegel einher.

Zur hochgenauen Prüfung der Spiegel ist insbesondere der Einsatz Computergenerierter Hologramme (CGH) bekannt.

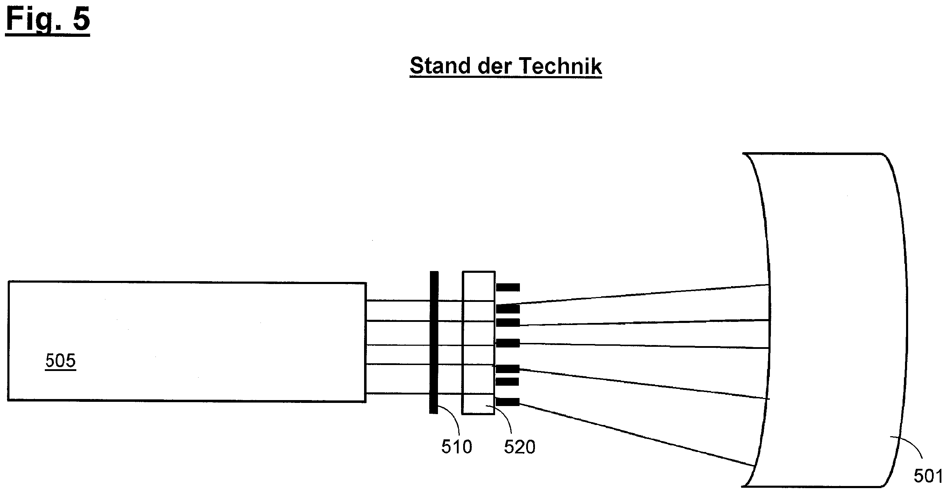

Fig. 5 zeigt zunächst eine schematische Darstellung zur Erläuterung eines möglichen Funktionsprinzips einer herkömmlichen interferometrischen Prüfanordnung zur Prüfung eines Spiegels 501.

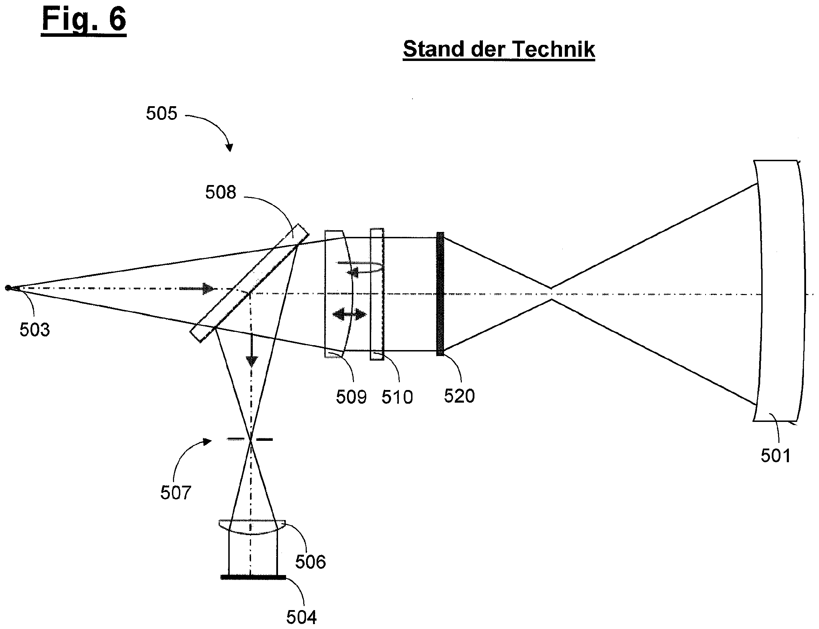

Gemäß Fig. 5 wird in einer Fizeau-Anordnung ein Interferogramm zwischen an einer Referenzfläche 510 ("Fizeau-Platte") reflektiertem Referenzlicht (Referenzwelle) und einem an dem Spiegel 501 reflektierten Messlicht (Prüfwelle) erzeugt. Dabei wird das Messlicht durch ein Computer-generiertes Hologramm (CGH) 520 zu einer asphärischen Wellenfront geformt, die mathematisch exakt der "Prüflingsform" (d.h. der Form des betreffenden Spiegels 501) in einem Sollabstand entspricht. Die von der Referenzfläche 510 einerseits und dem betreffenden Spiegel 501 bzw. Prüfling andererseits reflektierten Wellenfronten interferieren miteinander in einem (in Fig. 6 im Gesamtaufbau schematisch und bespielhaft dargestellten) Interferometer 505, wobei in Fig. 6 für das Interferometer 505 ein Kollimator 509, eine Strahlteilerplatte 508, eine Blende 507, ein Okular 506 und eine CCD-Kamera 504 sowie eine Lichtquelle 503 dargestellt sind. Mit der CCD-Kamera 504 wird ein Interferogramm des jeweiligen Spiegels aufgenommen.

Dabei tritt insbesondere bei GI-Spiegeln oder konkaven Spiegeln mit zunehmender Spiegelgröße in der Praxis das Problem auf, dass der Realisierung immer größerer CGH's Grenzen gesetzt sind, wobei typische CGH-Größen z.B. 6 Zoll (=15.24cm) oder 9 Zoll (=22.86cm) betragen können. Zwar kommt insoweit zur Reduzierung der benötigten CGH-Größen der Einsatz mehrerer CGH's für unterschiedliche, nacheinander eingestellte Spiegelpositionen in Betracht, jedoch ergeben sich in diesem Falle zusätzliche praktische Probleme, wobei insbesondere die Verlängerung der für die gesamte Prüfung benötigten zeitlichen Dauer sowie auch die Notwendigkeit einer exakten Zusammenführung der für die unterschiedlichen Spiegelbereiche erhaltenen Messergebnisse zu nennen sind.

Des Weiteren erweist es sich im Falle des Einsatzes mehrerer CGH's zur Prüfung ein- und desselben Spiegels als zunehmend schwierig, die in den CGH's typischerweise vorhandenen Fertigungsfehler von den im Rahmen der Prüfung zu ermittelnden Spiegelfehlern zuverlässig zu unterscheiden, wodurch im Ergebnis die Genauigkeit der Prüfung beeinträchtigt wird. Weitere Schwierigkeiten ergeben sich im Falle der Verwendung mehrerer CGH's aus den relativen Justagefreiheitsgraden (d.h. Abstände und relative Orientierung) von CGH und Spiegel zueinander.

Des Weiteren ist es bekannt, eine Kalibrierung der bei der Spiegelprüfung eingesetzten CGH's unter Verwendung sogenannter komplex-kodierter CGH's zu realisieren, wobei in ein- und dasselbe CGH an der gleichen Position zusätzlich zu der für die eigentliche Prüfung benötigten "Nutzfunktionalität" (d.h. der entsprechend der Spiegelform ausgelegten CGH-Struktur zur Formung der mathematisch der Prüflingsform entsprechenden Wellenfront) wenigstens eine weitere "Kalibrierfunktionalität" zur Bereitstellung einer zur Kalibrierung bzw. Fehlerkorrektur dienenden Referenzwellenfront einkodiert wird.

DE 10 2012 217 800 A1 offenbart u.a. ein diffraktives optisches Element mit einem Substrat sowie einem darauf angeordneten diffraktiven Strukturmuster, welches dazu konfiguriert ist, eine eingestrahlte ebene oder sphärische Eingangswelle in mindestens vier separate Ausgangswellen umzuwandeln. Hierbei werden neben einer nicht-sphärischen Ausgangswelle mindestens drei weitere Ausgangswellen erzeugt, die eben bzw. sphärisch sind, wodurch es u.a. möglich wird, das diffraktive optische Element auf Fertigungsfehler hin zu vermessen.

DE 10 2008 048 844 A1 offenbart u.a. ein Verfahren zum Vermessen einer Oberfläche eines Objekts, wobei ein variabler Lichtformer zwei in einem Strahlengang des Messlichts angeordnete Beugungsgitter umfasst, wobei unter Verlagern der Oberfläche des Objekts sowie Verlagern der beiden Beugungsgitter relativ zueinander unterschiedliche Teile der Oberfläche des Objekts mit Messlicht, welches den variablen Lichtformer durchsetzt hat, beleuchtet werden.

US 2012/0170038 A1 offenbart u.a. eine Vorrichtung zur Inspektion eines Spiegels, wobei ein Beleuchtungsstrahl F2, welcher über einen ein computer-generiertes Hologramm (CGH) umfassenden optischen Kompensator verläuft, nach Reflexion an einer Teilfläche der Oberfläche des zu prüfenden Spiegels mit einem Referenzstrahl F1 zur Überlagerung gebracht wird. Dabei werden durch translatorische Verschiebung der Anordnung zu jeweils unterschiedlichen Teilflächen des Spiegels aufeinanderfolgend photographische Aufnahmen der gesamten Spiegeloberfläche erzeugt.

Zum weiteren Stand der Technik wird lediglich beispielhaft auf US 7,936,521 B2, US 8,089,634 B2 sowie die Publikation Beyerlein, M.; Lindlein, N.; Schwider, J.: "Dual-wave-front computer-generated holograms for quasi-absolute testing of aspherics", Appl. Opt. (USA) 41, Seite 2440 (2002), verwiesen.

### ZUSAMMENFASSUNG DER ERFINDUNG

Vor dem obigen Hintergrund ist es eine Aufgabe der vorliegenden Erfindung, eine Prüfvorrichtung sowie ein Verfahren zum Prüfen eines Spiegels bereitzustellen, welche eine zuverlässige Prüfung auch von vergleichsweise großen Spiegelflächen unter zumindest teilweiser Vermeidung der vorstehend beschriebenen Probleme ermöglichen.

Diese Aufgabe wird durch die Merkmale der unabhängigen Patentansprüche gelöst.

Bei einer erfindungsgemäßen Prüfvorrichtung zum Prüfen eines Spiegels, insbesondere eines Spiegels einer mikrolithographischen Projektionsbelichtungsanlage, wobei die Prüfvorrichtung ein Computer-generiertes Hologramm (CGH) aufweist und wobei eine Prüfung zumindest einer Teilfläche des Spiegels durch interferometrische Überlagerung einer von diesem Computer-generierten Hologramm auf den Spiegel gelenkten Prüfwelle und einer Referenzwelle durchführbar ist, ist das Computer-generierte Hologramm derart ausgelegt, dass es im Betrieb der Vorrichtung eine erste Prüfwelle zur Prüfung einer ersten Teilfläche des Spiegels durch interferometrische Überlagerung mit einer Referenzwelle in einer ersten Position des Spiegels und wenigstens eine zweite Prüfwelle zur Prüfung einer zweiten Teilfläche des Spiegels durch interferometrische Überlagerung mit einer Referenzwelle in einer zweiten Position des Spiegels bereitstellt, wobei das Computer-generierte Hologramm zur Bereitstellung der ersten und der zweiten Prüfwelle eine komplexe Kodierung mit voneinander verschiedenen CGH-Strukturen aufweist

Der Erfindung liegt insbesondere das Konzept zugrunde, innerhalb ein- und desselben zur Spiegelprüfung eingesetzten CGH's mehrere "Nutzfunktionalitäten" zu kombinieren, welche jeweils unterschiedlichen geometrischen Bereichen auf dem zu messenden Spiegel (d.h. unterschiedlichen Messpositionen des Spiegels bzw. Prüflings in der jeweiligen Prüfanordnung) zugeordnet sind. Dabei wird hier und im Weiteren unter dem Begriff "Nutzfunktionalität" jeweils eine CGH-Struktur verstanden, welche (z.B. in Form eines räumlich variierenden Liniengitters) die jeweilige Wellenfront formt, welche der "Prüflingsform" in einem bestimmten Bereich bzw. auf einer bestimmten Teilfläche des zu prüfenden Spiegels entspricht und somit zur interferometrischen Prüfung dieses Bereichs des Spiegels geeignet ist.

Dabei wird die erfindungsgemäße Kombination der vorstehend genannten Nutzfunktionalitäten in ein- und demselben CGH unter Anwendung des für sich bekannten Konzepts der komplexen Kodierung realisiert, wobei jedoch erfindungsgemäß im Unterschied zu den eingangs beschriebenen, herkömmlichen komplex-kodierten CGH's eine Mehrzahl unterschiedlicher Nutzfunktionalitäten zur Prüfung unterschiedlicher Spiegelbereiche (d.h. nicht lediglich zum Zwecke der Kalibrierung bei der Prüfung ein- und desselben Spiegelbereichs) eingesetzt werden.

Mit anderen Worten wird erfindungsgemäß je nach dem, in welcher Position sich der zu prüfende Spiegel relativ zum CGH befindet, die Prüfwelle für einen ersten Bereich der Spiegelfläche (beispielsweise "linke Hälfte des Spiegels") oder die Prüfwelle für einen zweiten Bereich der Spiegelfläche (beispielsweise "rechte Hälfte des Spiegels") genutzt, wobei diese beiden Prüfwellen gerade durch das in entsprechender Weise komplex-kodierte CGH bereitgestellt werden.

Auf Grund der erfindungsgemäßen Kombination mehrerer Nutzfunktionalitäten in ein- und demselben CGH, welche unterschiedlichen geometrischen Bereichen des zu prüfenden Spiegels zugeordnet sind, kann eine Prüfung auch bei großen konkaven Spiegeln oder großen GI-Spiegeln ohne Wechsel des CGH's dadurch realisiert werden, dass lediglich der betreffende Spiegel bzw. Prüfling bei unveränderter Position des CGH's bewegt wird mit der Folge, dass sich die für unterschiedliche Spiegelbereiche erhaltenen, den jeweiligen Nutzfunktionalitäten zugeordneten Messergebnisse auf dem überlappenden Bereich nur durch Justagefreiheitsgrade des Prüflings unterscheiden.

Die Erfindung hat insbesondere den Vorteil, dass auch bei Prüfung vergleichsweise großer Spiegelflächen nur ein einziges CGH benötigt wird und dieses zudem an derselben Position verbleibt, so dass u.a. eine ggf. wiederholte CGH-Justage für unterschiedliche Spiegelstellungen innerhalb der Prüfanordnung entfällt.

Ein weiterer Vorteil besteht in einer erheblichen Reduzierung der für die Prüfung auch größerer Spiegelflächen erforderlichen Zeitdauer, was sich unmittelbar aus dem Wegfall herkömmlicher Prozeduren zum CGH-Wechsel sowie damit einhergehender Justageschritte etc. ergibt.

In Ausführungsformen der Erfindung ist die zweite Prüfwelle von der ersten Prüfwelle verschieden. Des Weiteren kann der Spiegel derart beschaffen sein, dass die zweite Teilfläche des Spiegels nicht durch eine Symmetrieoperation aus der ersten Teilfläche des Spiegels hervorgeht (wie dies etwa bei vorhandener Rotationssymmetrie des Spiegels der Falle wäre). Die Erfindung ermöglicht daher aufgrund der Bereitstellung unterschiedlicher Prüfwellen durch das Computer-generierte Hologramm (CGH), wobei voneinander verschiedenen Oberflächenbereichen bzw. Spiegelflächen jeweils eine dieser Prüfwellen zugeordnet ist, die Prüfung von Freiform-Spiegelflächen, welche keinerlei intrinsische Symmetrie aufweisen.

Gemäß der Erfindung weist das Computer-generierte Hologramm (CGH) zur Bereitstellung der ersten und der zweiten Prüfwelle eine komplexe Kodierung mit voneinander verschiedenen CGH-Strukturen auf.

Gemäß einer Ausführungsform ist das Computer-generierte Hologramm (CGH) ferner derart ausgelegt, dass die jeweiligen Intensitäten der ersten Prüfwelle und der zweiten Prüfwelle sich um nicht mehr als 20%, insbesondere um nicht mehr als 10%, voneinander unterscheiden.

Gemäß einer Ausführungsform ist das Computer-generierte Hologramm (CGH) ferner derart ausgelegt, dass es im Betrieb der Vorrichtung wenigstens eine Kalibrierwelle zur interferometrischen Überlagerung mit einer Referenzwelle nach Reflexion dieser Kalibrierwelle an einem Kalibrierspiegel bereitstellt.

Gemäß einer Ausführungsform ist das Computer-generierte Hologramm (CGH) ferner derart ausgelegt, dass es im Betrieb der Vorrichtung wenigstens zwei Kalibrierwellen, insbesondere wenigstens drei Kalibrierwellen, zur interferometrischen Überlagerung mit einer Referenzwelle nach Reflexion dieser Kalibrierwellen an voneinander verschiedenen Kalibrierspiegeln bereitstellt.

Die Erfindung betrifft weiter auch ein Verfahren zum Prüfen eines Spiegels, insbesondere eines Spiegels einer mikrolithographischen Projektionsbelichtungsanlage, wobei das Verfahren folgende Schritte aufweist:
- Aufnehmen eines ersten Interferogramms zwischen einer an dem Spiegel reflektierten ersten Prüfwelle und einer Referenzwelle;
- Aufnehmen eines zweiten Interferogramms zwischen einer an dem Spiegel reflektierten zweiten Prüfwelle und einer Referenzwelle;
- wobei die erste Prüfwelle und die zweite Prüfwelle von demselben Computer-generierten Hologramm (CGH) auf den Spiegel gelenkt werden, wobei das Computer-generierte Hologramm (CGH) zur Bereitstellung der ersten und der zweiten Prüfwelle eine komplexe Kodierung mit voneinander verschiedenen CGH-Strukturen aufweist; und
- wobei die Position des Spiegels zwischen dem Aufnehmen des ersten Interferogramms und dem Aufnehmen des zweiten Interferogramms verändert wird.

Gemäß einer Ausführungsform wird die erste Prüfwelle an einer ersten Teilfläche des Spiegels reflektiert, und die zweite Prüfwelle wird an einer von der ersten Teilfläche verschiedenen zweiten Teilfläche des Spiegels reflektiert.

Gemäß einer Ausführungsform wird der Spiegel zwischen dem Aufnehmen des ersten Interferogramms und dem Aufnehmen des zweiten Interferogramms verschoben und/oder um eine vorgegebene Achse (je nach Anwendung z.B. um die Gravitationsachse) verdreht.

Gemäß einer Ausführungsform verbleibt das Computer-generierte Hologramm (CGH) während der Aufnahme des ersten und zweiten Interferogramms in derselben Position.

Weitere Ausgestaltungen der Erfindung sind der Beschreibung sowie den Unteransprüchen zu entnehmen.

Die Erfindung wird nachstehend anhand von in den beigefügten Abbildungen dargestellten Ausführungsbeispielen näher erläutert.

### KURZE BESCHREIBUNG DER ZEICHNUNGEN

Es zeigen:
- Figur 1-4: schematische Darstellungen zur Erläuterung beispielhafter Ausführungsformen der vorliegenden Erfindung;
- Figur 5-6: schematische Darstellungen zur Erläuterung eines herkömmlichen Funktionsprinzips einer interferometrischen Prüfvorrichtung zur Prüfung eines Spiegels; und
- Figur 7: eine schematische Darstellung einer für den Betrieb im EUV ausgelegten Projektionsbelichtungsanlage.

### DETAILLIERTE BESCHREIBUNG

### BEVORZUGTER AUSFÜHRUNGSFORMEN

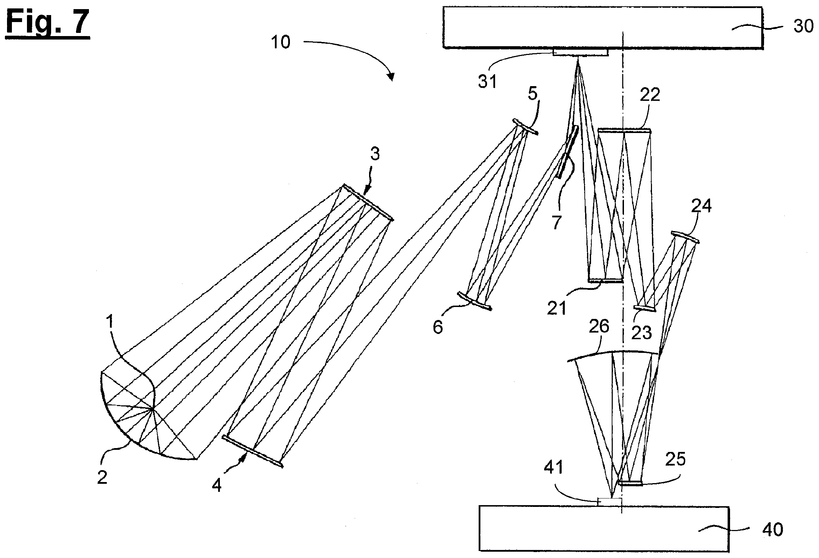

Fig. 7 zeigt zunächst eine schematische Darstellung einer beispielhaften für den Betrieb im EUV ausgelegten Projektionsbelichtungsanlage, welche mit einem erfindungsgemäßen Verfahren prüfbare Spiegel aufweist.

Gemäß Fig. 7 weist eine Beleuchtungseinrichtung in einer für EUV ausgelegten Projektionsbelichtungsanlage 10 einen Feldfacettenspiegel 3 und einen Pupillenfacettenspiegel 4 auf. Auf den Feldfacettenspiegel 3 wird das Licht einer Lichtquelleneinheit, welche eine Plasmalichtquelle 1 und einen Kollektorspiegel 2 umfasst, gelenkt. Im Lichtweg nach dem Pupillenfacettenspiegel 4 sind ein erster Teleskopspiegel 5 und ein zweiter Teleskopspiegel 6 angeordnet. Im Lichtweg nachfolgend ist ein Umlenkspiegel 7 angeordnet, der die auf ihn treffende Strahlung auf ein Objektfeld in der Objektebene eines sechs Spiegel 21-26 umfassenden Projektionsobjektivs lenkt. Am Ort des Objektfeldes ist eine reflektive strukturtragende Maske 31 auf einem Maskentisch 30 angeordnet, die mit Hilfe des Projektionsobjektivs in eine Bildebene abgebildet wird, in welcher sich ein mit einer lichtempfindlichen Schicht (Photoresist) beschichtetes Substrat 41 auf einem Wafertisch 40 befindet.

Bei dem im Rahmen der Erfindung geprüften Spiegel kann es sich z.B. um einen beliebigen Spiegel der Projektionsbelichtungsanlage 10, beispielsweise die Spiegel 21 oder 22 des Projektionsobjektivs oder auch den Spiegel 7 der Beleuchtungseinrichtung, handeln.

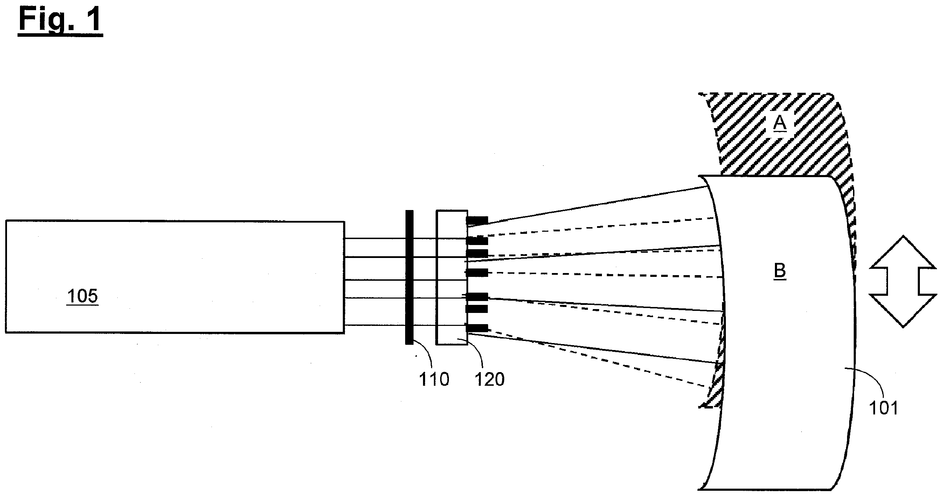

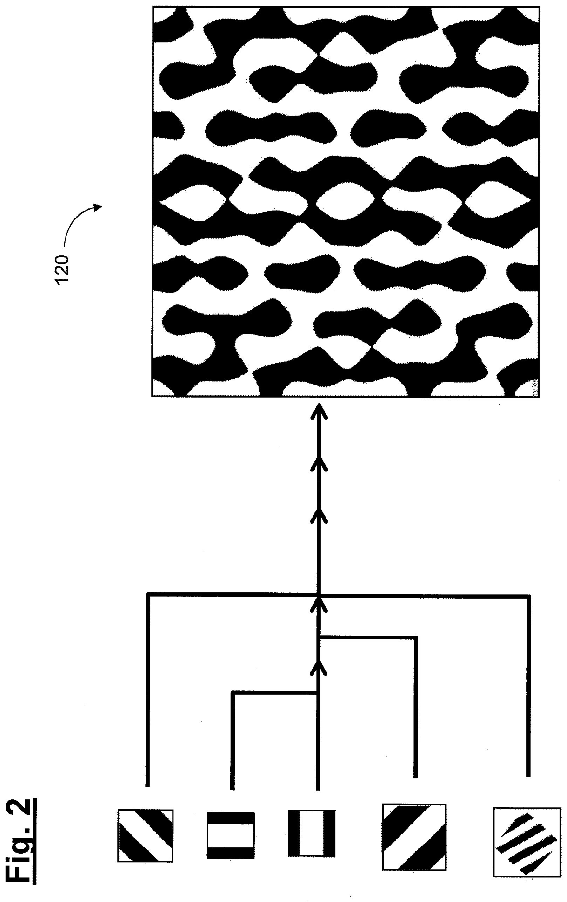

Im Weiteren wird zunächst ein der Erfindung zugrundeliegendes Prinzip unter Bezugnahme auf die schematischen Abbildungen in Fig. 1 und 2 beschrieben.

Fig. 1 zeigt zunächst ausgehend von der bereits anhand von Fig. 5 beschriebenen Fizeau-Anordnung eine schematische Darstellung zur Erläuterung der Prüfung eines Spiegels 101 unter Nutzung des an einer Referenzfläche 110 ("Fizeau-Platte") reflektierten Referenzlichtes und des an dem zu prüfenden Spiegel 101 reflektierten Messlichtes, wobei das Messlicht durch ein Computer-generiertes Hologramm (CGH) 120 zu einer Wellenfront geformt wird, die mathematisch exakt der "Prüfungsform" (d.h. der Form des betreffenden Spiegels 101) in einem Sollabstand entspricht. Die von der Referenzfläche 110 einerseits und dem entsprechenden Spiegel 101 bzw. Prüfling andererseits reflektierten Wellenfronten interferieren miteinander in einem Interferometer 105, welches z.B. den bereits anhand von Fig. 6 erläuterten Gesamtaufbau besitzen kann.

Erfindungsgemäß erfolgt eine Prüfung des Spiegels 101 unter Nutzung ein- und desselben CGH's 120 für die gesamte zu prüfende Spiegelfläche des Spiegels 101, wozu der Spiegel 101 (wie in Fig. 1 durch den Doppelpfeil angedeutet) in unterschiedliche Positionen innerhalb der Prüfvorrichtung bewegt wird. In Fig. 1 sind lediglich schematisch zwei unterschiedliche Positionen "A" und "B" angedeutet.

In diesen unterschiedlichen Spiegelpositionen "A" und "B" innerhalb der Prüfvorrichtung erfolgt (im Hinblick auf die angenommene große Spiegelfläche) jeweils die Prüfung nur eines Teilbereichs der gesamten Spiegelfläche, wobei für diese Prüfung das CGH 120 entsprechend der in Fig. 2 gezeigten Prinzipskizze mit einer Mehrzahl unterschiedlicher CGH-Strukturen bzw. Nutzfunktionalitäten ausgestattet ist. Bei diesen CGH-Strukturen bzw. Nutzfunktionalitäten kann es sich typischerweise, wie in Fig. 2 angedeutet, um (lokal variierende) Liniengitter unterschiedlicher Orientierung bzw. Gitterperiode handeln.

Mit anderen Worten weist das CGH 120 sowohl eine zur Prüfung eines ersten Spiegelbereichs (bei in Position "A" befindlichem Spiegel 101) geeignete erste CGH-Struktur bzw. Nutzfunktionalität als auch eine zur Prüfung eines zweiten Spiegelbereichs (entsprechend der Position "B" des Spiegels 101) geeignete CGH-Struktur bzw. Nutzfunktionalität auf.

Diese CGH-Strukturen bzw. Nutzfunktionalitäten werden in dem CGH 120 im Wege des für sich bekannten Verfahrens der komplexen Kodierung realisiert. Hierbei können die jeweiligen CGH-Strukturen bzw. Liniengitter jeweils durch eine Phasenfunktion (mit Amplitude und Phase) beschrieben werden, wobei die betreffenden Terme mit gegebenenfalls unterschiedlichen Gewichtungen aufaddiert werden können. Auf diese Weise ergibt sich eine komplexe Funktion, welche wiederum binarisiert werden kann, womit z.B. die im rechten Teil von Fig. 2 lediglich schematisch für einen bestimmten Punkt auf dem CGH dargestellte resultierende Struktur des CGH 120 erhalten wird.

Die betreffende, im rechten Teil von Fig. 2 schematisch dargestellte resultierende Gesamtstruktur des CGH 120 zeichnet sich dabei insbesondere dadurch aus, dass infolge der vorstehend beschriebenen komplexen Kodierung eine Mehrzahl von Prüfwellen für ein- und denselben Prüfling bzw. Spiegel bereitgestellt wird, wobei diese Prüfwellen voneinander verschiedenen Teilflächen des Spiegels zugeordnet sind, also im Wege einer Verschiebung des Spiegels 101 relativ zum CGH 120 eine interferometrische Prüfung auch einer vergleichsweise großen, aus den jeweiligen Teilflächen zusammengesetzten Spiegelfläche bei Verwendung ein- und desselben CGH 120 ermöglichen.

In den nachfolgenden Tabellen 1a und 1b werden beispielhafte Ausführungsformen für die vorstehend beschriebene, mögliche Gewichtung der einzelnen CGH-Strukturen angegeben.

Wie aus Tabelle 1a und Tabelle 1b jeweils ersichtlich sind hierbei die (als "Gitter 1" bzw. "Gitter 2") bezeichneten Liniengitter der Nutzfunktionalitäten (d.h. der CGH-Strukturen zur Prüfung der einzelnen Teilflächen des Spiegels 101) relativ zu den (als "Gitter 3" bis "Gitter 5") bezeichneten Kalibrierfunktionalitäten relativ stark gewichtet, wobei zudem die Gewichtung der beiden Nutzfunktionalitäten bzw. "Gitter 1" und "Gitter 2" relativ zueinander übereinstimmt (oder in weiteren Ausführungsformen nur geringfügig, z.B. weniger als 20%, insbesondere weniger als 10% bezogen auf die jeweils stärkere Gewichtung voneinander abweichen). Zusätzlich zu den vorstehend genannten beiden Nutzfunktionalitäten bzw. CGH-Strukturen sind auf dem CGH 120 im Ausführungsbeispiel weitere (Nutz- oder auch Kalibrier-) Funktionalitäten kodiert (Gitter 3, Gitter 4 und Gitter 5 in Tabelle 1a und 1b).

**Tabelle 1a:**

| Gitter | Gewichtung | Intensität 1. Ordnung | Reflektivität Spiegel | Gesamtintensität nach CGH (zweifacher Durchlauf) + Spiegel |
|---|---|---|---|---|
| 1 | 40 | 11% | 4.00% | 0.05% |
| 2 | 40 | 11% | 4.00% | 0.05% |
| 3 | 20 | 2.5% | 80.00% | 0.05% |
| 4 | 20 | 2.5% | 80.00% | 0.05% |
| 5 | 20 | 2.5% | 80.00% | 0.05% |

**Tabelle 1b:**

| Gitter | Gewichtung | Intensität 1. Ordnung | Reflektivität Spiegel | Gesamtintensität nach CGH (zweifacher Durchlauf) + Spiegel |
|---|---|---|---|---|
| 1 | 50 | 12% | 4.00% | 0.06% |
| 2 | 50 | 12% | 4.00% | 0.06% |
| 3 | 20 | 1.8% | 80.00% | 0.03% |
| 4 | 20 | 1.8% | 80.00% | 0.03% |
| 5 | 20 | 1.8% | 80.00% | 0.03% |

Im Ausführungsbeispiel von Fig. 2 weist das CGH 120 infolge der komplexen Kodierung insgesamt fünf unterschiedliche Funktionalitäten bzw. CGH-Strukturen auf, wobei lediglich beispielhaft zwei dieser CGH-Strukturen zur Prüfung unterschiedlicher Spiegelbereiche (bei Positionierung des Spiegels 101 in den anhand von Fig. 1 dargestellten Spiegelpositionen "A" und "B") dienen können, und wobei die übrigen drei CGH-Strukturen als Kalibrierfunktionalitäten dienen können.

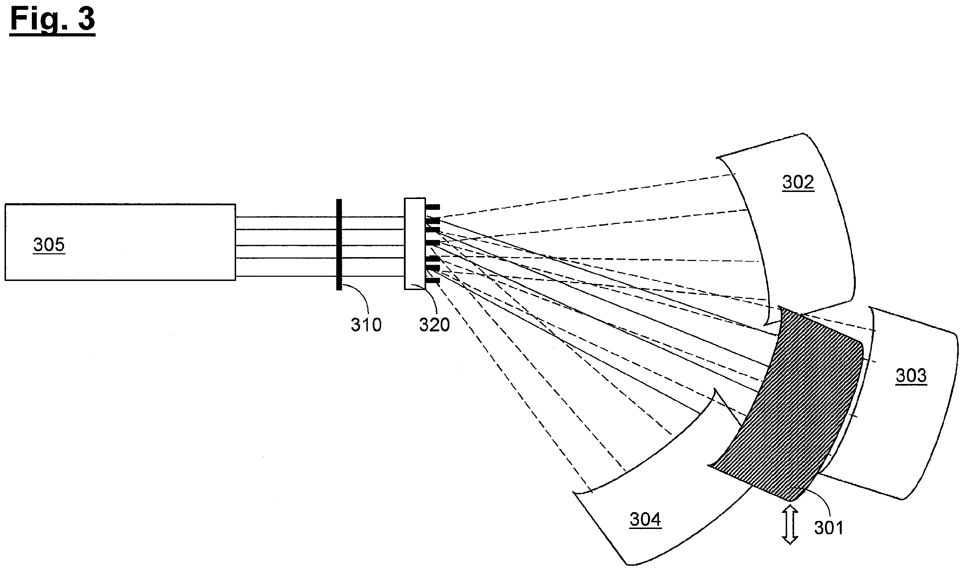

Fig. 3 zeigt hierzu eine schematische Darstellung, wobei zu Fig. 1 analoge bzw. im Wesentlichen funktionsgleiche Komponenten mit um "200" erhöhten Bezugsziffern bezeichnet sind. Die Prüfvorrichtung gemäß Fig. 3 weist insgesamt drei Kalibrierspiegel 302, 303 und 304 auf, denen jeweils eine der vorstehend beschriebenen Kalibrierfunktionalitäten des CGH 320 zugeordnet ist. Der Spiegel 301 wird (wie durch den Doppelpfeil in Fig. 3 angedeutet) zur Prüfung unterschiedlicher Spiegelbereiche wie bereits zuvor beschrieben in unterschiedliche Positionen innerhalb der Prüfvorrichtung bewegt, wobei zur Prüfung die entsprechend dem jeweiligen Spiegelbereich ausgelegte bzw. diesem zugeordnete Nutzfunktionalität des CGH 320 genutzt wird.

Gemäß einem weiteren Aspekt der Erfindung kann die Prüfung eines Spiegels unter Verwendung ein- und desselben CGH's (und unter Bewegen bzw. Verschieben der Spiegelposition relativ zu diesem CGH) auch dazu genutzt werden, den Einfluss unerwünschter Störreflexe auf das Prüfergebnis zu verringern bzw. weitgehend zu eliminieren. Solche Störreflexe resultieren typischerweise daraus, dass zusätzlich zu den erwünschten, durch Beugung an den jeweiligen CGH-Strukturen auf die Spiegelfläche treffenden und von dieser reflektierten Prüfwelle auch weitere, bei der Prüfung jedoch nicht erwünschte Beugungsordnungen zufällig bzw. aufgrund unvermeidbarer Fehler innerhalb der CGH-Struktur ebenfalls nach Reflexion an der Spiegelfläche auf demselben Weg wie die gewünschten Prüfwellen zurücklaufen und ebenfalls zu dem erzeugten Interferogramm beitragen können.

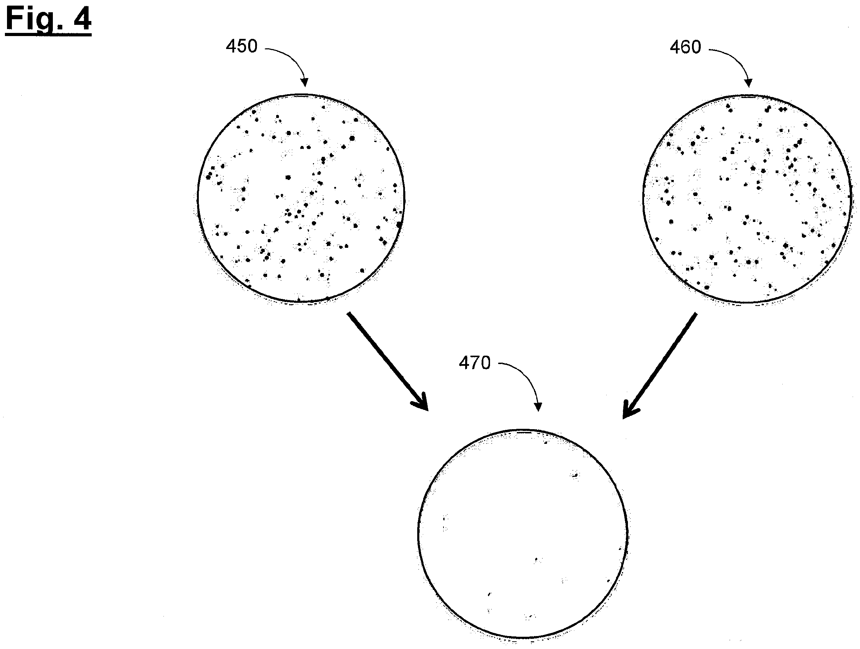

Erfindungsgemäß kann nun zur Überwindung oder Reduzierung dieses Problems die interferometrische Messung mit ein- und demselben CGH für z.B. zwei zueinander verdrehte oder geringfügig verschobene Spiegelstellungen erfolgen, wobei anschließend, wie in Fig. 4 angedeutet, eine "Oder-Verknüpfung" der beiden erhaltenen Interferogramme 450, 460 durchgeführt wird mit der Folge, dass die aus dieser Oder-Verknüpfung resultierende Verteilung 470 vom Einfluss von Störreflexen ("Speckle-Muster") zumindest weitgehend befreit ist.

Im vorstehend beschriebenen Ausführungsbeispiel kann somit die Nutzung ein- und desselben CGH in Verbindung mit zwei unterschiedlichen Spiegelstellungen relativ zu dem CGH auch in Anwendungen vorteilhaft genutzt werden, bei denen das CGH bereits aufgrund Größe und Ausgestaltung eine unmittelbare Prüfung der gesamten Spiegelfläche in einem einzigen Schritt (d.h. ohne Teilschritte für einzelne Teilflächen des Spiegels) ermöglicht.

Ein weiterer vorteilhafter Aspekt der erfindungsgemäßen komplexen Kodierung eines CGH mit mehreren Nutzfunktionalitäten ist, dass mit einem solchen CGH (wie z.B. in Fig. 2 gezeigt) auch die Prüfung von Freiform-Spiegelflächen (welche keinerlei intrinsische Symmetrie aufweisen) ermöglicht wird, wobei auch hier ausgenutzt wird, dass auf ein- und dieselbe Position auf dem CGH unterschiedliche Nutzfunktionalitäten einkodiert bzw. unterschiedliche Liniengitter eingeschrieben werden können.

Die erfindungsgemäße Bereitstellung von wenigstens zwei Nutzfunktionalitäten auf ein- und derselben Position des CGH kann ferner - alternativ zur Messung unterschiedlicher Teilflächen des Spiegels - auch zur Messung unterschiedlicher Spiegelgeometrien genutzt werden, in welchem Falle die einzelnen Nutzfunktionalitäten bzw. CGH-Strukturen in diesem Falle nicht unterschiedlichen Teilflächen desselben Spiegels, sondern unterschiedlichen Spiegeln zugeordnet sind.

Des Weiteren muss die Bereitstellung von wenigstens zwei Nutzfunktionalitäten nicht auf der gesamten CGH-Fläche erfolgen, so dass die Nutzfunktionalitäten auch jeweils nur auf einem Teilbereich des CGH eingeschrieben sein können. In diesem Falle muss die gegebenenfalls vorhandene Kalibrierfunktionalität die jeweiligen Teilbereiche der Nutzfunktionalitäten umfassen.

Des Weiteren ist die Erfindung nicht auf eine bestimmte Anzahl von Nutzfunktionalitäten oder eine bestimmte Anzahl von Kalibrierfunktionalitäten entsprechend den vorstehend beschriebenen Ausführungsformen beschränkt, so dass insbesondere auch mehr als zwei Nutzfunktionalitäten bzw. CGH-Strukturen, welche jeweils einer von mehreren Teilflächen des Spiegels zugeordnet sein können, möglich sind.

Wenn die Erfindung auch anhand spezieller Ausführungsformen beschrieben wurde, erschließen sich für den Fachmann zahlreiche Variationen und alternative Ausführungsformen, z.B. durch Kombination und/oder Austausch von Merkmalen einzelner Ausführungsformen. Dementsprechend versteht es sich für den Fachmann, dass derartige Variationen und alternative Ausführungsformen von der vorliegenden Erfindung mit umfasst sind und die Reichweite der Erfindung nur im Sinne der beigefügten Patentansprüche beschränkt ist.

## Patentansprüche

1. Prüfvorrichtung zum Prüfen eines Spiegels, insbesondere eines Spiegels einer mikrolithographischen Projektionsbelichtungsanlage, wobei die Prüfvorrichtung ein Computer-generiertes Hologramm (CGH) aufweist und wobei eine Prüfung zumindest einer Teilfläche des Spiegels durch interferometrische Überlagerung einer von diesem Computer-generierten Hologramm auf den Spiegel gelenkten Prüfwelle und einer Referenzwelle durchführbar ist,
wobei das Computer-generierte Hologramm (CGH) (120, 320) derart ausgelegt ist, dass es im Betrieb der Vorrichtung eine erste Prüfwelle zur Prüfung einer ersten Teilfläche des Spiegels (101, 301) durch interferometrische Überlagerung mit einer Referenzwelle in einer ersten Position des Spiegels (101, 301) und wenigstens eine zweite Prüfwelle zur Prüfung einer zweiten Teilfläche des Spiegels (101, 301) durch interferometrische Überlagerung mit einer Referenzwelle in einer zweiten Position des Spiegels (101, 301) bereitstellt;
**dadurch gekennzeichnet, dass**
das Computer-generierte Hologramm (CGH) (120, 320) zur Bereitstellung der ersten und der zweiten Prüfwelle eine komplexe Kodierung mit voneinander verschiedenen CGH-Strukturen aufweist.

2. Prüfvorrichtung nach Anspruch 1, **dadurch gekennzeichnet, dass** das Computer-generierte Hologramm (CGH) (120, 320) ferner derart ausgelegt ist, dass die jeweiligen Intensitäten der ersten Prüfwelle und der zweiten Prüfwelle sich um nicht mehr als 20%, insbesondere um nicht mehr als 10%, voneinander unterscheiden.

3. Prüfvorrichtung nach Anspruch 1 oder 2, **dadurch gekennzeichnet, dass** das Computer-generierte Hologramm (CGH) (120, 320) ferner derart ausgelegt ist, dass es im Betrieb der Vorrichtung wenigstens eine Kalibrierwelle zur interferometrischen Überlagerung mit einer Referenzwelle nach Reflexion dieser Kalibrierwelle an einem Kalibrierspiegel (302, 303, 304) bereitstellt.

4. Prüfvorrichtung nach Anspruch 3, **dadurch gekennzeichnet, dass** das Computer-generierte Hologramm (CGH) (120, 320) ferner derart ausgelegt ist, dass es im Betrieb der Vorrichtung wenigstens zwei Kalibrierwellen, insbesondere wenigstens drei Kalibrierwellen, zur interferometrischen Überlagerung mit einer Referenzwelle nach Reflexion dieser Kalibrierwellen an voneinander verschiedenen Kalibrierspiegeln (302, 303, 304) bereitstellt.

5. Verfahren zum Prüfen eines Spiegels, insbesondere eines Spiegels einer mikrolithographischen Projektionsbelichtungsanlage, wobei das Verfahren folgende Schritte aufweist:
• Aufnehmen eines ersten Interferogramms zwischen einer an dem Spiegel (101, 301) reflektierten ersten Prüfwelle und einer Referenzwelle;
• Aufnehmen eines zweiten Interferogramms zwischen einer an dem Spiegel (101, 301) reflektierten zweiten Prüfwelle und einer Referenzwelle;
• wobei die erste Prüfwelle und die zweite Prüfwelle von demselben Computer-generierten Hologramm (CGH) (120, 320) auf den Spiegel (101, 301) gelenkt werden, wobei das Computer-generierte Hologramm (CGH) (120, 320) zur Bereitstellung der ersten und der zweiten Prüfwelle eine komplexe Kodierung mit voneinander verschiedenen CGH-Strukturen aufweist; und
• wobei die Position des Spiegels (101, 301) zwischen dem Aufnehmen des ersten Interferogramms und dem Aufnehmen des zweiten Interferogramms verändert wird.

6. Verfahren nach Anspruch 5, **dadurch gekennzeichnet, dass** die erste Prüfwelle an einer ersten Teilfläche des Spiegels reflektiert wird und die zweite Prüfwelle an einer von der ersten Teilfläche verschiedenen zweiten Teilfläche des Spiegels reflektiert wird.

7. Verfahren nach Anspruch 5 oder 6, **dadurch gekennzeichnet, dass** der Spiegel zwischen dem Aufnehmen des ersten Interferogramms und dem Aufnehmen des zweiten Interferogramms verschoben und/oder verdreht wird.

8. Verfahren nach einem der Ansprüche 5 bis 7, **dadurch gekennzeichnet, dass** das Computer-generierte Hologramm (CGH) (120, 320) während der Aufnahme des ersten und zweiten Interferogramms in derselben Position verbleibt.

## Claims

1. Test appliance for testing a mirror, in particular a mirror of a microlithographic projection exposure apparatus, wherein the test appliance comprises a computer-generated hologram (CGH) and wherein a test can be carried out on at least a portion of the mirror by way of an interferometric superposition of a test wave that is directed onto the mirror by this computer-generated hologram and a reference wave,
wherein the computer-generated hologram (CGH) (120, 320) is designed in such a way that, during operation of the appliance, it provides a first test wave for testing a first portion of the mirror (101, 301) by interferometric superposition with a reference wave in a first position of the mirror (101, 301) and at least a second test wave for testing a second portion of the mirror (101, 301) by interferometric superposition with a reference wave in a second position of the mirror (101, 301);
**characterized in that**
the computer-generated hologram (CGH) (120, 320) for providing the first test wave and the second test wave has a complex encoding of CGH structures that differ from one another.

2. Test appliance according to Claim 1, **characterized in that** the computer-generated hologram (CGH) (120, 320) is further designed in such a way that the respective intensities of the first test wave and of the second test wave differ by no more than 20%, in particular by no more than 10%, from one another.

3. Test appliance according to Claim 1 or 2, **characterized in that** the computer-generated hologram (CGH) (120, 320) is further designed in such a way that, during operation of the appliance, it provides at least one calibration wave for the interferometric superposition with a reference wave after the reflection of this calibration wave at a calibration mirror (302, 303, 304).

4. Test appliance according to Claim 3, **characterized in that** the computer-generated hologram (CGH) (120, 320) is further designed in such a way that, during operation of the appliance, it provides at least two calibration waves, in particular at least three calibration waves, for the interferometric superposition with a reference wave after the reflection of these calibration waves at calibration mirrors (302, 303, 304) that differ from one another.

5. Method for testing a mirror, in particular a mirror of a microlithographic projection exposure apparatus, wherein the method comprises the following steps:
• recording a first interferogram between a first test wave that is reflected at the mirror (101, 301) and a reference wave;
• recording a second interferogram between a second test wave that is reflected at the mirror (101, 301) and a reference wave;
• wherein the first test wave and the second test wave are directed onto the mirror (101, 301) by the same computer-generated hologram (CGH) (120, 320), wherein the computer-generated hologram (CGH) (120, 130) for providing the first test wave and the second test wave has a complex encoding of CGH structures that differ from one another; and
• wherein the position of the mirror (101, 301) is modified between the recording of the first interferogram and the recording of the second interferogram.

6. Method according to Claim 5, **characterized in that** the first test wave is reflected at a first portion of the mirror and the second test wave is reflected at a second portion of the mirror that is different from the first portion.

7. Method according to Claim 5 or 6, **characterized in that** the mirror is displaced and/or twisted between the recording of the first interferogram and the recording of the second interferogram.

8. Method according to any one of Claims 5 to 7, **characterized in that** the computer-generated hologram (CGH) (120, 320) remains in the same position during the recording of the first interferogram and of the second interferogram.

## Revendications

1. Appareil de contrôle destiné au contrôle d'un miroir, en particulier d'un miroir d'un système d'exposition microlithographique, l'appareil de contrôle comportant un hologramme synthétique et dans lequel un contrôle d'au moins une surface partielle du miroir peut être effectué par superposition interférométrique d'une onde de contrôle, déviée sur le miroir, de cet hologramme synthétique et d'une onde de référence,
dans lequel l'hologramme synthétique (120, 320) est disposé de telle sorte que lors du fonctionnement de l'appareil, il fournit une première onde de contrôle destinée à contrôler une première surface partielle du miroir (101, 301) par superposition interférométrique avec une onde de référence dans une première position du miroir (101, 301) et au moins une deuxième onde de contrôle destinée à contrôler une deuxième surface partielle du miroir (101, 301) par superposition interférométrique avec une onde de référence dans une deuxième position du miroir (101, 301) ;
caractérisé en ce l'hologramme synthétique (120, 320) comporte un encodage complexe avec des structures d'hologrammes synthétiques différentes les unes des autres pour la fourniture des premières et deuxièmes ondes de contrôle.

2. Appareil de contrôle selon la revendication 1, **caractérisé en ce que** l'hologramme synthétique (120, 320) est en outre disposé de telle sorte que les intensités respectives de la première onde de contrôle et de la deuxième onde de contrôle ne diffèrent pas l'une de l'autre de plus de 20 %, en particulier pas de plus de 10 %.

3. Appareil de contrôle selon la revendication 1 ou 2, **caractérisé en ce que** l'hologramme synthétique (120, 320) est en outre disposé de telle sorte que, lors du fonctionnement de l'appareil, il fournit au moins une onde d'étalonnage pour superposition interférométrique avec une onde de référence après réflexion de cette onde d'étalonnage sur un miroir d'étalonnage (302, 303, 304) .

4. Appareil de contrôle selon la revendication 3, **caractérisé en ce que** l'hologramme synthétique (120, 320) est en outre disposé de telle sorte que, lors du fonctionnement de l'appareil, il fournit au moins deux ondes d'étalonnage pour superposition interférométrique avec une onde de référence après réflexion de ces ondes d'étalonnage sur des miroirs d'étalonnage différents les uns des autres (302, 303, 304).

5. Procédé de contrôle d'un miroir, en particulier d'un miroir d'un système d'exposition microlithographique, le procédé comprenant les étapes suivantes :
• enregistrement d'un premier interférogramme entre une première onde de contrôle réfléchie sur le miroir (101, 301) et une onde de référence ;
• enregistrement d'un deuxième interférogramme entre une deuxième onde de contrôle réfléchie sur le miroir (101, 301) et une onde de référence ;
• dans lequel la première onde de contrôle et la deuxième onde de contrôle de ce même hologramme synthétique (120, 320) sont déviées sur le miroir (101, 301), dans lequel l'hologramme synthétique (120, 320) comporte un encodage complexe avec des structures d'hologrammes synthétiques différentes les unes des autres pour la fourniture des première et deuxième ondes de contrôle ; et
• dans lequel la position du miroir (101, 301) est modifiée entre l'enregistrement du premier interférogramme et l'enregistrement du deuxième interférogramme.

6. Procédé selon la revendication 5, **caractérisé en ce que** la première onde de contrôle est réfléchie sur une première surface partielle du miroir et la deuxième onde de contrôle est réfléchie sur une deuxième surface partielle du miroir différente de la première surface partielle.

7. Procédé selon la revendication 5 ou 6, **caractérisé en ce que** le miroir est décalé et/ou pivoté entre l'enregistrement du premier interférogramme et l'enregistrement du deuxième interférogramme.

8. Procédé selon l'une des revendications 5 à 7, **caractérisé en ce que** l'hologramme synthétique (120, 320) reste dans la même position pendant l'enregistrement du premier interférogramme et du deuxième interférogramme.
